# EUROPÄISCHE PATENTSCHRIFT

(11) **EP 2 698 640 B1**
(45) Veröffentlichungstag und Bekanntmachung des Hinweises auf die Patenterteilung: **26.04.2023**
(21) Anmeldenummer: 13003567.8
(22) Anmeldetag: 16.07.2013
(51) Int. Cl.: G01R 1/073

(54) **Prüfkopf für die elektrische Prüfung eines Prüflings**
Test head for electrical testing of a test object
Tête de test pour le contrôle électrique d'un objet de test

(30) Priorität: 16.08.2012 DE 102012016449
(43) Veröffentlichungstag der Anmeldung: 19.02.2014
(73) Patentinhaber: Feinmetall GmbH, 71083 Herrenberg (DE)
(72) Erfinder: Treuz, Stefan, 72411 Bodelshausen (DE); Böhm, Gunther, 71154 Nufringen (DE); Weiland, Achim, 68199 Mannheim (DE)
(74) Vertreter: Clarenbach, Carl-Philipp

(56) Entgegenhaltungen:
- DE-A1- 19 847 244
- US-A- 5 773 988
- US-A- 5 956 835
- US-A- 5 990 696
- US-A1- 2008 048 685

## Beschreibung

Die Erfindung betrifft einen Prüfkopf für die elektrische Prüfung eines Prüflings, insbesondere Wafers, mit mindestens zwei, mittels mindestens eines Abstandshalters beabstandet zueinander angeordneten Führungsplatten, die über ihre Fläche verteilt angeordnete Führungsbohrungen aufweisen, in denen Prüfkontaktstifte zur Berührungskontaktierung des Prüflings verschieblich geführt sind.

Derartige Prüfköpfe sind für die Prüfung elektrischer und elektronischer Schaltungen, insbesondere für die Prüfung von Wafern, bekannt. Für die elektrische Prüfung werden Prüfkontaktstifte des Prüfkopfs mit entsprechenden elektrischen Flächenkontakten des Prüflings in Berührungskontaktierung gebrachte, beispielsweise dadurch, dass der Prüfling mittels einer Hubeinrichtung angehoben und dabei gegen die Enden der Prüfkontaktstifte gedrängt wird. Die anderen Enden der Prüfkontaktstifte treten bei der Kontaktierung des Prüflings gegen Flächenkontakte einer Kontaktabstandsvergrößerungseinrichtung, die dazu dient den Kontaktabstand zu vergrößern. In diesem Zusammenhang ist anzumerken, dass die Flächenkontakte des Wafers auf engstem Raum liegen, sodass die Prüfkontaktstifte, die insbesondere als Knickdrähte ausgebildet sind, nur minimale Kontaktabstände voneinander aufweisen. Mit der Kontaktabstandsvergrößerungseinrichtung können die Kontaktabstände derart vergrößert werden, dass es möglich ist, mittels Anschlussleitungen eine Prüfeinrichtung anzuschließen, die bei der elektrischen Prüfung Prüfwege schaltet, um den Prüfling auf elektrische Funktionsfähigkeit zu prüfen. Die Prüfkontaktstifte werden mittels Führungsplatten gehalten, wobei mindestens zwei Führungsplatten beabstandet zueinander angeordnet sind und Führungsbohrungen aufweisen, die von den Prüfkontaktstiften durchgriffen werden. Die Führungsplatten sind aus elektrisch nicht leitendem Material, beispielsweise Keramik. Die Prüfkontaktstifte bestehen aus elektrisch sehr gut leitendem Werkstoff, der gleichzeitig eine gewisse Elastizität aufweist, damit die Prüfkontaktstifte bei der Berührungskontaktierung geringfügig seitlich ausbiegen können. Um die mindestens zwei Führungsplatten relativ zueinander zu positionieren und auf Abstand zu halten, ist ein Abstandshalter vorgesehen, der aus mehreren, über die gesamten Längen der Platten verlaufenden, mit Abstand benachbart zueinander angeordneten Querstreben gebildet ist. Diese Querstreben nehmen relativ viel Platz ein, der nicht als Prüffläche zur Verfügung steht, da dort keine Prüfkontaktstifte angeordnet werden können. Ferner besteht der Nachteil, dass durch Temperatureinfluss die Kontaktgenauigkeit nicht stets gewährleistet ist, da eine Art Bimetalleffekt auftritt, der zu Verwerfungen führen kann, d.h., die Prüfkontaktstifte setzen ungenau oder gar nicht auf die zu kontaktierenden Flächenkontakte des Prüflings und/oder der Kontaktabstandsvergrößerungseinrichtung auf, mit der Folge, dass Fehlmessungen durchgeführt werden. Die Temperaturbeeinflussung liegt insbesondere dann vor, wenn der Prüfling während der elektrischen Prüfung unterschiedlichen Testtemperaturen ausgesetzt wird, um seine Funktionsfähigkeit in einem Temperaturbereich zu prüfen. Der Temperaturbereich kann von zweistelligen Minustemperaturen bis zu dreistelligen Plustemperaturen reichen.

Die Offenlegungsschrift US 5,956,835 A offenbart einen Prüfkopf der gattungsgemäßen Art. Der Prüfkopf weist Punktabstützungen zur Fixierung und Beabstandung von Führungsplatten auf. An Außenseiten der Führungsplatten angeordnete Punktabstützungen weisen einstellbare Beabstandungselemente auf, sodass unterschiedliche Abstände zwischen den Führungsplatten wählbar sind.

Der Erfindung liegt daher die Aufgabe zugrunde, einen Prüfkopf der eingangs genannten Art anzugeben, der eine hochgenaue Kontaktierung gewährleistet, die auch bei unterschiedlichen Temperaturen stets erhalten bleibt, wobei ferner eine vergrößerte Prüffläche zur Verfügung steht.

Diese Aufgabe wird erfindungsgemäß durch einen Prüfkopf mit den Merkmalen des Anspruchs 1 gelöst. Dieser sieht vor, dass der Abstandshalter von einer Vielzahl von über die Flächen der Führungsplatten verteilt angeordneten, an den Führungsplatten befestigten Punktabstützungen gebildet ist. Unter "Punktabstützungen" sind Abstandselemente zu verstehen, die in der Fläche der jeweiligen Führungsplatte nur einen relativ kleinen Querschnitt einnehmen. Demzufolge ist der Gesamtquerschnitt von mehreren, beispielsweise reihenförmig über die Flächen der Führungsplatten verteilt angeordneten Abstandselementen wesentlich kleiner als die Querschnittsfläche einer bekannten Querstrebe, die sich über den entsprechend gleichen Bereich erstreckt. Der Zwischenraum zwischen den bei der Erfindung vorgesehene Abstandselementen kann zur Aufnahme von Prüfkontaktstiften, also als aktive Prüffläche, genutzt werden. Die Bezeichnung "Punktabstützungen" bedeutet nicht, dass der gebildete Abstandshalter die beiden Führungsplatten sehr eng benachbart abstützt, sondern sie können einen vorgebbaren Abstand voneinander aufweisen, wobei dann die jeweilige Punktabstützung eine relativ geringe Fläche, jedoch eine entsprechend wählbar große Länge aufweist. Die über die Flächen der Führungsplatten verteilt angeordneten, an den Führungsplatten befestigten Punktabstützungen schaffen einen sehr steifen Verbund der beteiligten Bauelemente, mit der Folge, dass ein Durchbiegen von mindestens einer Führungsplatte vermieden oder im Wesentlichen vermieden ist. Dieses Durchbiegen kommt beispielsweise dann zustande, wenn eine sehr hohe Prüfkontaktstiftdichte vorliegt und die Prüfkontaktstifte zum axialen Federn leicht bogenförmig verlaufen, sodass beim Berührungskontaktieren Reibungskräfte der Prüfkontaktstifte in den Führungsbohrungen entstehen, die zu dem erwähnten Verbiegen der mindestens einen Führungsplatte führen. Da gegenüber den streifenförmigen Querstreben des Standes der Technik aufgrund der Erfindung ein steiferer Verbund geschaffen wird, ist das Verbiegungsproblem der mindestens einen Führungsplatte gelöst, da aufgrund der über die Fläche verteilt angeordneten Punktabstützungen die Steifigkeit der Anordnung sehr groß ist.

Nach einer Weiterbildung der Erfindung ist vorgesehen, dass die eine Führungsplatte eine erste Führungsplatte und dass die andere Führungsplatte eine zweite Führungsplatte ist, wobei die zweite Führungsplatte eine prüflingsnahe Führungsplatte und die erste Führungsplatte eine prüflingsentfernte Führungsplatte ist. Die zweite Führungsplatte ist daher in Richtung Prüfling beziehungsweise einer Prüflingsaufnahme orientiert. Die erste Führungsplatte ist in Richtung der Kontaktabstandsvergrößerungseinrichtung beziehungsweise der Prüfeinrichtung orientiert.

Es ist - nach einer Weiterbildung der Erfindung - vorgesehen, dass eine weitere, dritte Führungsplatte benachbart zur ersten Führungsplatte angeordnet ist, wobei jedem Prüfkontaktstift eine erste Führungsbohrung in der ersten Führungsplatte, eine zweite Führungsbohrung in der zweiten Führungsplatte und eine dritte Führungsbohrung in der dritten Führungsplatte zugeordnet ist, wobei die zweite und dritte Führungsbohrung miteinander fluchten und die erste Führungsbohrung versetzt zu der Fluchtung von der zweiten und dritten Führungsbohrung liegt oder alle drei Führungsbohrungen zueinander versetzt liegen. Dieser, bei der erstgenannten Alternative genannte Versatz der ersten Führungsbohrung zwingt den jeweiligen Prüfkontaktstift in eine Bogenform, die bei der Berührungskontaktierung des Prüflings eine axiale Federwirkung mit sich bringt. Ferner tritt bei dem Aufsetzen des jeweiligen Prüfkontaktstifts auf die Prüffläche des Prüflings ein sogenannter Scrub auf, d.h., das Prüfkontaktstiftende kratzt ein winziges Stück quer zur Längserstreckung des Prüfkontaktstifts an der Kontaktfläche entlang, wodurch die elektrischen Kontaktwerte verbessert werden. Beispielsweise wird dadurch eine Oxidschicht auf der Kontaktoberfläche durchdrungen. Alternativ ist es jedoch auch möglich, dass die Führungsplatten nichtfluchtende Führungsbohrungen aufweisen, d.h., alle Führungsbohrungen liegen versetzt zueinander. Die Prüfkontaktstifte werden dann entsprechend gebogen geführt. Nach einer weiteren Ausführungsform der Erfindung kann auch vorgesehen sein, dass zwischen der zweiten und der dritten Führungsbohrung ein minimaler Versatz besteht. Die erste Führungsbohrung kann dann mit einer der Führungsbohrungen, also mit der zweiten Führungsbohrung oder mit der dritten Führungsbohrung fluchten oder sie fluchtet weder mit der zweiten noch mit der dritten Führungsbohrung (wie bereits erwähnt).

Nach einer Weiterbildung der Erfindung ist vorgesehen, dass die Punktabstützungen als Stützstreben, insbesondere druck- und zugfeste Stützstreben, ausgebildet sind. Bei diesen Stützstreben handelt es sich somit um stiftförmige Bauteile, die zur Bildung des Abstandshalters in Längserstreckung zwischen den Führungsplatten angeordnet sind. Aufgrund ihrer Druck- und Zugfestigkeit bilden die Stützstreben zusammen mit den Führungsplatten ein steifes gegen Durchbiegung resistentes Gebilde.

Erfindungsgemäß weist jede der Punktabstützungen eine Längserstreckungsrichtung und quer, insbesondere rechtwinklig, dazu eine Vielzahl von über einen Winkelbereich von 360° verteilte Radialrichtungen auf.

Die Anordnung ist erfindungsgemäß derart getroffen, dass die mechanische Festigkeit jeder der Punktabstützungen in mindestens einer der Radialrichtungen kleiner ist als in den anderen Radialrichtungen. Die Punktabstützungen sind daher über den Winkelbereich von 360° in den Radialrichtungen mit unterschiedlicher mechanischer Festigkeit ausgestattet, wobei in mindestens einer der Radialrichtungen die mechanische Festigkeit kleiner als in den übrigen Radialrichtungen ist. Es besteht daher dort eine gewisse "Weichheit". In der Praxis wird dieser Radialrichtung eine um 180° versetzte weitere Radialrichtung zuordenbar sein, die ebenfalls die kleinere mechanische Festigkeit aufweist. Der Begriff "Radialrichtung" ist vorzugsweise als ein Radialrichtungswinkelbereich zu verstehen, denn die mechanische Festigkeit der Punktabstützungen wird sich in unterschiedlichen Radialrichtungen nicht schlagartig, sondern kontinuierlich ändern.

Nach einer Weiterbildung der Erfindung ist vorgesehen, dass jede der Punktabstützungen zur Erzielung der kleineren mechanischen Festigkeit mindestens eine Querschnittsschwächungszone aufweist. Damit wird über einen bestimmten Radialrichtungs-Winkelbereich eine hohe mechanische Festigkeit erzielt, nämlich dort, wo die mindestens eine Querschnittsschwächungszone keine Wirkung entfaltet. In dem Winkelbereich, in dem die Querschnittsschwächungszone wirkt, kommt es zu der kleineren mechanischen Festigkeit der jeweiligen Punktabstützung, wodurch eine geringfügige Biegung der Punktabstützung möglich.

Insbesondere kann vorgesehen sein, dass jede der Punktabstützungen auf einander gegenüberliegenden Seiten ihres Umfangs jeweils eine Querschnittsschwächungszone aufweist. Damit ergibt sich in einem bestimmten Radialwinkelbereich quasi eine Taille der jeweiligen Punktabstützung, mit der Folge einer entsprechend winkelorientierten Verkleinerung der mechanischen Festigkeit.

Nach einer Weiterbildung der Erfindung ist vorgesehen, dass jede der Punktabstützungen in Längserstreckungsrichtung eine erste Endzone und daran anschießend eine Mittelzone und daran anschließend eine zweite Endzone aufweist und dass die Mittelzone die mindestens eine Querschnittsschwächungszone besitzt. In der Längserstreckungsrichtung kann daher im Bereich der Mittelzone ein leichtes Biegen der entsprechenden Punktabstützung erfolgen, wenn entsprechende Kräfte auftreten. Nach einer Weiterbildung der Erfindung kann vorgesehen sein, dass jede der Punktabstützungen im Bereich der mindestens einen Querschnittsschwächungszone mindestens einen Durchbruch aufweist. In dem Bereich, nämlich in der Mittelzone, in der die mindestens eine Querschnittsschwächungszone liegt, kann daher mindestens ein Durchbruch vorgesehen sein, der zur umfangswinkelabhängigen Festigkeitsreduzierung beiträgt.

Ist vorzugsweise mindestens ein Durchbruch vorgesehen, so werden hierdurch mindestens zwei Stützarme zwischen den Endzonen der jeweiligen Punktabstützung ausgebildet. Dies bedeutet, dass in einer Ebene, in der die beiden Stützarme liegen eine hohe Biegesteifigkeit vorliegt. In einer 90° dazu liegenden Ebene, zu der die beiden Stützarme beidseitig liegen ist daher eine geringere Biegesteifigkeit vorhanden, sodass hier die erwähnte kleinere mechanische Festigkeit gegeben ist. Trotz der mindestens einen Querschnittsschwächungszone und/oder des mindestens einen Durchbruchs insbesondere zur Ausbildung der Stützarme, ist aufgrund der erwähnten Druck- und Zugfestigkeit der Punktabstützungen über deren Längserstreckung eine hohe Stabilität gegeben, sodass es nicht zu Durchbiegungen der Führungsplatten kommt.

Die Anordnung ist vorzugsweise derart getroffen, dass die Stützarme zueinander parallel verlaufen und dass die Stützarme parallel zur Längserstreckungsrichtung der jeweiligen Punktabstützung verlaufen.

Eine Weiterbildung der Erfindung sieht vor, dass die beiden Endzonen Stirnseiten zum Abstützen an den Führungsplatten aufweisen. Die einzelnen Punktabstützungen werden daher so zwischen den Führungsplatten angeordnet, dass die jeweils an ihren beiden Endzonen ausgebildeten Stirnseiten gegen die Führungsplatten treten und diese daher abstützen.

Nach einer Weiterbildung der Erfindung ist vorgesehen, dass an mindestens einer der Stirnseiten ein Element einer Verdrehsicherung vorhanden ist, das mit einem zur Verdrehsicherung gehörenden Gegenelement an der zugehörigen Führungsplatte zusammenwirkt. Hierdurch erhält die jeweilige Punktabstützung eine feste, durch die Verdrehsicherung gesicherte Drehwinkelausrichtung, sodass - in Bezug auf die Flächen der Führungsplatten - die Radialrichtung mit der geringeren mechanischen Festigkeit eine vorbestimmbare und feste Position einnimmt. Die Vielzahl der Punktabstützungen lassen sich auf diese Art und Weise in gewünschter Drehwinkelposition anordnen. Sie lassen sich bei Bedarf derart positionieren, dass ihre Wirkrichtungen mit der kleineren mechanischen Festigkeit unterschiedlich oder gleichgerichtet sind und/oder dass zum Beispiel Gruppen von Punktabstützungen mit unterschiedlicher oder mit gleichgerichteter Wirkrichtung kleinerer mechanischer Festigkeit vorliegen.

Um die beiden Führungsplatten über den Abstandshalter aneinander zu befestigen, ist insbesondere vorgesehen, dass die Stirnseiten der Punktabstützungen mit Befestigungsbohrungen, insbesondere Gewindebohrungen, versehen sind, in die die Führungsplatten durchgreifende Befestigungselemente, insbesondere Gewindeschraubelemente, mit Enden ihrer Schäfte eingreifen. Die Befestigungselemente werden bevorzugt als Gewindeschraubelemente ausgebildet, die mit ihren Gewindeschäften in die mit Innengewinde versehenen Befestigungsbohrungen eingeschraubt sind und auf diese Art und Weise die Führungsplatten halten.

Ferner ist bevorzugt vorgesehen, dass das Element der Verdrehsicherung mindestens ein von der zugehörigen Befestigungsbohrung radial beabstandeter Vorsprung ist und dass das Gegenelement eine Vertiefung in der Führungsplatte ist. Der Vorsprung greift in die Vertiefung der Führungsplatte ein und schafft dadurch die Verdrehsicherung der jeweils zugehörigen Punktabstützung.

Nach einer Weiterbildung der Erfindung ist vorgesehen, dass die einer der Stirnseiten zugeordneten Befestigungselemente mit ihren Schäften zwei der Führungsplatte durchgreifen, wobei zwischen diesen beiden Führungsplatten Abstandsbauteile, insbesondere von den Schäften durchsetzte Abstandshülsen, angeordnet sind, die sich an diesen Führungsplatten abstützen. Hierdurch sind zwei Führungsplatten an der einen Seite der Punktabstützungen angeordnet, die durch die Abstandsbauteile zueinander beabstandet liegen. Auf der anderen Seite der Punktabstützungen ist eine weitere Führungsplatte angeordnet. Diese drei Führungsplatten bilden die erwähnte erste, zweite sowie dritte Führungsplatte. Die dritte Führungsplatte ist die außen liegende, von den Abstandshülsen gestützte Führungsplatte und die zweite Führungsplatte ist die von den den Abstandshülsen entfernt liegenden Stirnseiten abgestützte Führungsplatte. Die erste Führungsplatte ist diejenige, die zwischen den beiden, vorstehend erwähnten Führungsplatten liegt und die sich einerseits an den Stirnseiten der Punktabstützungen und andererseits an den Enden der Abstandshülsen abstützt.

Erfindungsgemäß ist vorgesehen, dass die Punktabstützungen derart drehorientiert über die Flächen der Führungsplatten angeordnet sind, dass die Wirkrichtungen kleinerer mechanischer Festigkeit auf das Zentrum der jeweiligen Führungsplatte weisend ausgerichtet sind. Diese Anordnung hat insbesondere bei einem Prüflingstest mit Temperaturbeaufschlagung Vorteile, da aufgrund der Erwärmung des Prüflings beziehungsweise aufgrund dessen Kühlung davon auszugehen ist, dass sich die prüflingsnahe Führungsplatte stärker erwärmt beziehungsweise stärker abkühlt als die mindestens eine, weitere, vom Prüfling entfernt liegende Führungsplatte, mit der Folge, dass sich bezüglich der Ebene der Führungsplatte kleine Verschiebungen ergeben, um die Temperaturunterschiede auszugleichen. Diese Verschiebungen erfolgen aufgrund der Temperaturausdehnungskoeffizienten der Materialien. Da die Punktabstützungen aufgrund der Wirkrichtungen mit kleinerer mechanischer Festigkeit in einer Richtung "weicher" ausgebildet sind und die Wirkrichtungen auf das Zentrum der Führungsplatten weisen, erfolgt stets eine Verschiebung aus der Mitte heraus, sodass sich die Verschiebungswerte nicht all zu groß aufsummieren. Bei den Verschiebungen der beiden Führungsplatten relativ zueinander nehmen die Punktabstützungen eine entsprechend leicht gebogene Form ein, wobei dies aufgrund der Zentrumsausrichtung der Wirkrichtungen mit geringerer mechanischer Festigkeit quasi rotationssymmetrisch auf den Flächen der Führungsplatten erfolgt. Vorzugsweise sind die Punktabstützungen matrixartig und/oder linienförmig über die Flächen der Führungsplatten verteilt angeordnet.

Schließlich sieht eine bevorzugte Weiterbildung der Erfindung einen Prüfkopf vor, bei dem zur Ausbildung einer Mittenzentriervorrichtung für die Aufnahme von Führungsstiften mindestens drei Langlochausnehmungen vorgesehen sind, wobei die Längserstreckungsrichtungen der Langlochausnehmungen auf das Zentrum der jeweiligen Führungsplatte weisend ausgerichtet sind. Erfolgt bei einer Temperaturbeaufschlagung beispielsweise eine Ausdehnung des Prüfkopfs, so sorgt die Mittenzentriervorrichtung dafür, dass diese Ausdehnung aus der Mitte, also aus dem Zentrum heraus, erfolgt. Die drei Langlochausnehmungen können beispielsweise um 120° versetzt zueinander angeordnet sein, jedoch sind auch andere Winkelanordnungen denkbar.

Die Erfindung betrifft ferner eine Prüfvorrichtung mit einem Prüfkopf, so wie er vorstehend beschrieben ist, wobei die mindestens drei vorzugsweise ortsfest angeordneten Führungsstifte vorgesehen sind, die in die mindestens drei Langlochausnehmungen in der jeweiligen Längserstreckungsrichtung der Langlochausnehmungen gleitbar eingreifen.

Die Zeichnungen veranschaulichen die Erfindung anhand eines Ausführungsbeispiels und zwar zeigt:
- Figur 1: eine schematische Ansicht eines Bereichs eines Prüfkopfs für die elektrische Prüfung eines Prüflings,
- Figur 2: eine Punktabstützung des Prüfkopfs,
- Figur 3: die Punktabstützung der Figur 2 im eingebauten Zustand zur Abstützung von Führungsplatten des Prüfkopfs,
- Figur 4: eine Prüfeinrichtung mit Prüfkopf in perspektivischer Ansicht,
- Figur 5: eine der Führungsplatten,
- Figur 6: einen Teilbereich einer Führungsplatte und
- Figur 7: eine perspektivische Schnittansicht durch einen Teilbereich des Prüfkopfs.

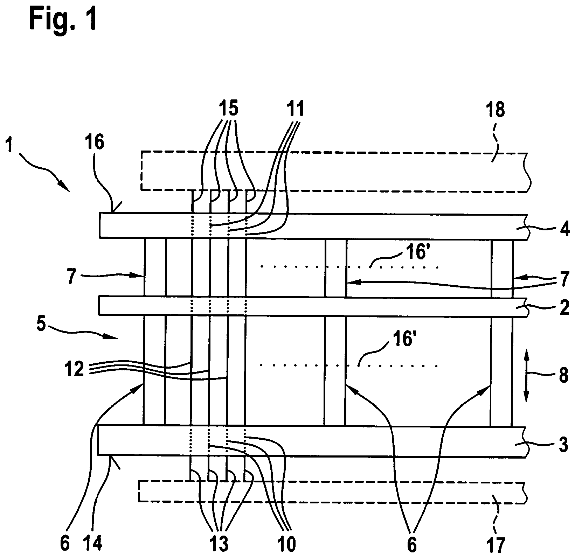

Die Figur 1 zeigt einen Bereich eines Prüfkopfs 1, der mehrere Führungsplatten 2, 3 und 4 aufweist, die beabstandet zueinander, insbesondere parallel beabstandet zueinander angeordnet sind. Hierzu ist zwischen den Führungsplatten 2 und 3 ein Abstandshalter 5 angeordnet, der von einer Vielzahl von über die Flächen der Führungsplatten 2 und 3 verteilt angeordneten, an den Führungsplatten 2 und 3 befestigten Punktabstützungen 6 gebildet ist. Ferner sind hierzu Abstandsbauteile 7 zwischen den Führungsplatten 2 und 4 angeordnet. Die Anordnung ist nun so getroffen, dass die Führungsplatte 2 eine erste Führungsplatte 2, dass die Führungsplatte 3 eine zweite Führungsplatte 3 und dass die Führungsplatte 4 eine dritte Führungsplatte 4 bildet. Die Abstandsbauteile 7 sind ebenfalls in über die Flächen der Führungsplatten 2 und 4 verteilter Anordnung positioniert, wobei sie vorzugsweise - in Axialrichtung (Pfeil 8) gesehen - mit den Punktabstützungen 6 fluchten.

Die erste Führungsplatte 2 weist eine Vielzahl von Führungsbohrungen 9 auf, die erste Führungsbohrungen bilden, die zweite Führungsplatte 3 weist eine Vielzahl von Führungsbohrungen 10 auf, die zweite Führungsbohrungen bilden, und die dritte Führungsplatte 4 besitzt eine Vielzahl von Führungsbohrungen 11, die dritte Führungsbohrungen 11 bilden. Die Führungsbohrungen 9 bis 11 werden von Prüfkontaktstiften 12 verschieblich durchsetzt, wobei ihre Enden 13 die Unterseite 14 der zweiten Führungsplatte 3 und ihre anderen Enden 15 die Oberseite 16 der dritten Führungsplatte 4 überragen. Die Anordnung ist nun so getroffen, dass die zweiten Führungsbohrungen 10 und die dritten Führungsbohrungen 11 miteinander fluchten und dass die ersten Führungsbohrungen 9 versetzt zu dieser Fluchtung liegen, sodass die Prüfkontaktstifte 12 eine geringfügige Bogenform aufweisen. Der Übersichtlichkeit halber sind in Figur 1 nur einige Prüfkontaktstifte 12 dargestellt. In der Realität liegen diese Prüfkontaktstifte 12 sehr eng beieinander und es ist eine sehr große Anzahl vorhanden. Dies wird durch die gepunkteten Linien 16' angedeutet. Alternativ ist es auch möglich, dass - bei einem nicht dargestellten Ausführungsbeispiel der Erfindung - die Führungsbohrungen in den drei Führungsplatten derart angeordnet sind, dass sie alle zueinander versetzt liegen.

Aus der Figur 1 geht ferner ein Prüfling 17 hervor, der einer elektrischen Prüfung unterzogen werden soll. Vorzugsweise handelt es sich bei dem Prüfling 17 um einen Wafer. Ferner zeigt die Figur 1 eine Kontaktsabstandsvergrößerungsvorrichtung 18, die elektrisch mit einer Prüfeinrichtung verbunden ist (nicht dargestellt). Um nun eine elektrische Prüfung des Prüflings 17 vorzunehmen, wird dieser mittels einer geeigneten, nicht dargestellten Hubvorrichtung gegen die Enden 13 der Prüfkontaktstifte 12 gefahren, sodass Flächenkontakte des Prüflings 17 in Berührungskontakt zu den Prüfkontaktstiften 12 gelangen. Ferner setzen dabei die Enden 15 der Prüfkontaktstifte 12 auf Flächenkontakte der Kontaktsabstandsvergrößerungsvorrichtung 18 auf, sodass auch dort eine Berührungskontaktierung stattfindet. Nunmehr kann mittels der nicht dargestellten Prüfeinrichtung die Prüfung durchgeführt werden, indem Stromkreise geschaltet und der elektrische Prüfling 17 auf Funktionsfähigkeit geprüft wird. Bei dieser Prüfung, die mehrere Stunden andauern kann, wird zumeist auch eine Temperaturprüfung durchgeführt. Dies bedeutet, dass der Prüfling 17 mindestens einer erniedrigten und mindestens einer erhöhten Temperatur, beispielsweise in einem Temperaturbereich von - 30°C bis + 200°C augesetzt wird, um auch unter diesen Bedingungen die elektrische Funktionsfähigkeit zu prüfen. Während der gesamten Prüfung, also auch bei Temperaturbeaufschlagung, ist es erforderlich, dass die Berührungskontaktierung zum Prüfling 17 und die Berührungskontaktierung zur Kontaktsabstandsvergrößerungsvorrichtung 18 einwandfrei erhalten bleibt, was aufgrund der extrem kleinen Kontaktabstände eine entsprechend hochgenaue Führung und ein hochgenaues Halten der Prüfkontaktstifte 12 mittels der Führungsplatten 2 bis 4 sowie des Abstandshalters 5 und der Abstandsbauteile 7 bedeutet.

Nachstehend wird auf die konkrete Ausgestaltung der einzelnen, aus der Figur 1 ersichtlichen Bauteile näher eingegangen.

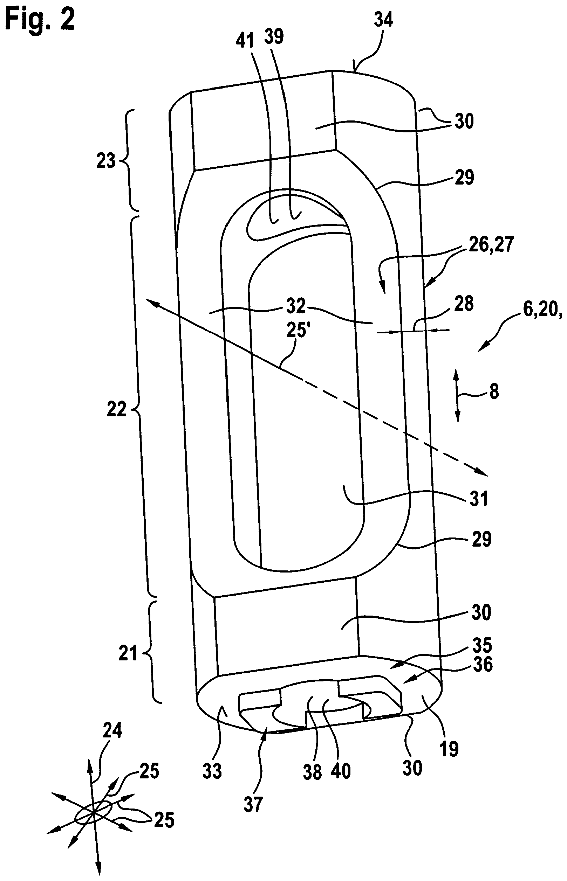

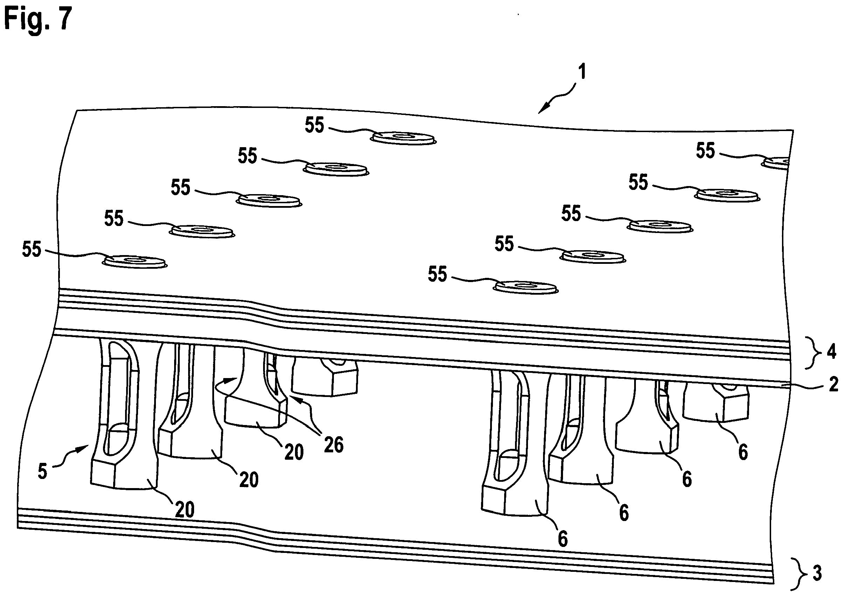

Die Figur 2 zeigt eine Punktabstützung 6. Bei der Punktabstützung 6 handelt es sich um ein Abstandselement, das im Wesentlichen stabförmig ausgebildet ist, also in Richtung seiner Längserstreckung (Pfeil 8) ein größeres Maß aufweist als quer dazu, sodass nur ein relativ kleiner Querschnitt 19 vorliegt. Die Punktabstützung 6 ist als druck- und zugfeste Stützstrebe 20 ausgebildet, d.h., in Richtung der Längserstreckung (Pfeil 8) kann die Stützstrebe 20 sowohl Zug- als auch Druckkräfte verformungsfrei aufnehmen. Die Punktabstützung 6 besitzt in Längserstreckungsrichtung eine erste Endzone 21, eine sich daran anschließende Mittelzone 22 und eine daran anschlie-ßende zweite Endzone 23. Zur Orientierung ist die Längserstreckungsrichtung 24 in der Figur 2 angegeben, sie läuft in dieselbe Richtung wie die bereits erwähnte Axialrichtung (Pfeil 8). Quer dazu, insbesondere rechtwinklig dazu, verlaufen eine Vielzahl von über einen Winkelbereich von 360° verteile Radialrichtungen 25, von denen einige in der Figur 2 angedeutet sind. Die Anordnung ist nun derart getroffen, dass die mechanische Festigkeit der Punktabstützung 6 in einer bestimmten Radialrichtung, nämlich der Radialrichtung 25' kleiner ist als in den anderen Radialrichtungen 25. Wird demzufolge die Punktabstützung 6 in Radialrichtung 25' beaufschlagt, so lässt sie sich geringfügig bogenförmig verbiegen. In den übrigen Radialrichtungen 25 tritt bei entsprechender Belastung dieses Verbiegen nicht auf. Diese geringere mechanische Festigkeit, also eine gewisse "Weichheit", wird bewusst dadurch erzielt, dass die Punktabstützung 6 aufeinander gegenüberliegende Seiten ihres Umfangs jeweils eine Querschnittsschwächungszone 26 (siehe auch Figur 7) aufweist. Die jeweilige Querschnittsschwächungszone 26 ist durch eine randoffene, in der Mittelzone 22 liegende Ausnehmung 27 gebildet. Zwischen den beiden Ausnehmungen 27 verbleibt demgemäß nur ein schmaler, streifenförmiger Materialbereich 18. Die jeweilige Ausnehmung 27 läuft an ihren beiden Enden mittels eines Bogens 29 aus. Der Grundriss der beiden Endzonen 21 und 23, der dem Querschnitt 19 entspricht, ist etwa stadionförmig, insbesondere kreisförmig mit auf einander gegenüberliegenden Seiten angeordneten Abplattungen 30 ausgebildet. Im Bereich der Mittelzone 22, also im Bereich der Querschnittsschwächungszone 26 wird die Punktabstützung 6 von einem Durchbruch 31 durchsetzt, der einen stadionförmigen Querschnitt aufweist und zur Materialschwächung der Querschnittsschwächungszone 26 beiträgt. Aufgrund des Durchbruchs 31 werden in der Mittelzone 22 zwei parallel zueinander verlaufende Stützarme 32 ausgebildet. Die beiden Stützarme 32 verlaufen parallel zur Längserstreckungsrichtung 24. Die beiden Endzonen 21 und 23 weisen jeweils eine Stirnseite 33 und 34 auf, die dem Abstützen an den zugeordneten Führungsplatten 2 und 3 dienen. An der Stirnseite 33 ist ein Element 35 einer Verdrehsicherung 36 ausgebildet, das mit einer der Führungsplatten 2 oder 3 zusammenwirkt, je nach dem, wie herum die Punktabstützung 6 montiert wird. Das Element 35 ist als Vorsprung 37 ausgebildet, der beidseitig zu einer Befestigungsbohrung 38 liegt, wobei die Befestigungsbohrung 38 in axialer Richtung, also in Längserstreckungsrichtung 24, verläuft. Eine entsprechende Befestigungsbohrung 39 geht von der Stirnseite 34 aus. Die Befestigungsbohrung 38 durchsetzt die erste Endzone 21 und mündet in den Durchbruch 31; die Befestigungsbohrung 39 durchsetzt die Endzone 23 und mündet ebenfalls in den Durchbruch 31. Die beiden Befestigungsbohrungen 38 und 39 weisen jeweils ein Innengewinde 40, 41 auf. Der Vorsprung 37 ist radial zur zugehörigen Befestigungsbohrung 38 angeordnet und weist keine rotationssymmetrische Struktur auf. Diese asymmetrische Struktur des Elements 35 der Verdrehsicherung 36 besitzt eine feste Winkelzuordnung zu der Radialrichtung 25', in der eine geringere mechanische Festigkeit besteht.

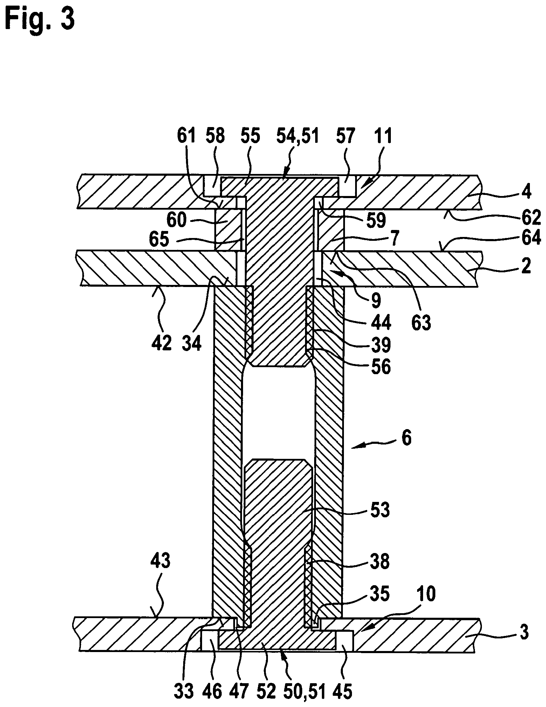

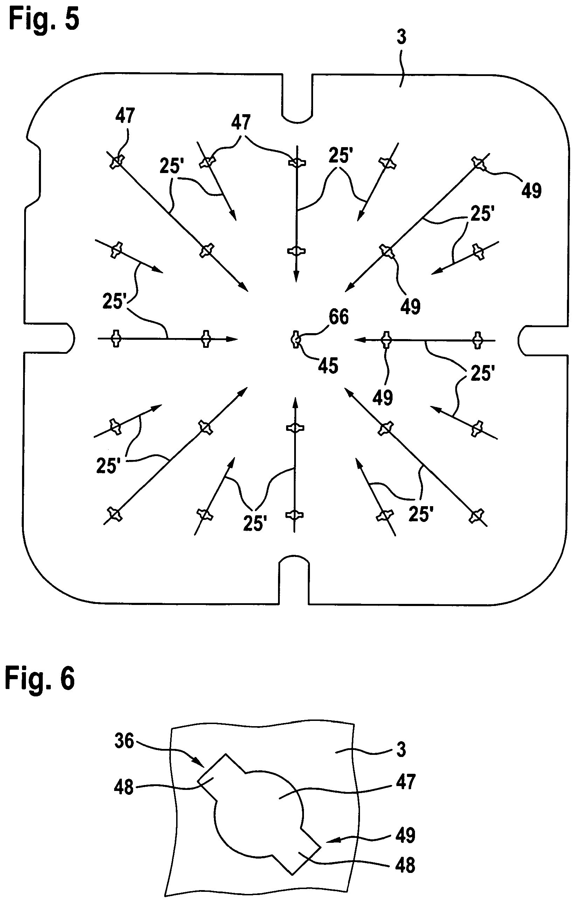

Die Figur 3 zeigt die Punktabstützung 6 im eingebauten Zustand, d.h., sie ist zwischen der ersten Führungsplatte 2 und der zweiten Führungsplatte 3 derart angeordnet, dass sich die Stirnseite 34 an der Unterseite 42 der Führungsplatte 2 und die Stirnseite 33 und der Oberseite 43 der Führungsplatte 3 abstützt. Die Führungsplatte 2 ist mit einer Durchgangsbohrung 44 versehen, die mit der Befestigungsbohrung 39 fluchtet. Die Führungsplatte 3 ist mit einer Stufenbohrung 45 versehen, die die Führungsplatte 3 durchsetzt und die mit der Befestigungsbohrung 38 fluchtet. Die Stufenbohrung 45 weist einen durchmessergrößeren Abschnitt 46 und durchmesserkleineren Abschnitt 47 auf. In Figur 6 ist der durchmesserkleinere Abschnitt 47 ersichtlich, der auf einander gegenüberliegenden Seiten in eine Vertiefung 48 bildenden Ausnehmungen übergeht. Diese Vertiefung 48 bilden ein Gegenelement 49 zum Element 35 und dient zusammen mit dem Element 35 zur Bildung der Verdrehsicherung 36. In diesem Zusammenhang ist aus der Figur 3 erkennbar, dass der Vorsprung 37 in die Vertiefung 48 eingreift. Dies bedeutet, dass die Punktabstützung 6 relativ zur Führungsplatte 3 winkelorientiert festgelegt ist, sich also nicht verdrehen kann. Zur Befestigung von Führungsplatte 3 und Punktabstützung 6 aneinander ist ein als Gewindeschraubelement 50 ausgebildetes Befestigungselement 51 vorgesehen. Das Gewindeschraubelement 50 weist einen Kopf 52 und einen mit Gewinde versehenen Schaft 53 auf. Die Anordnungen sind so getroffen, dass das Gewinde des Schafts 53 in das Innengewinde 40 der Befestigungsbohrung 38 eingeschraubt ist, wobei der Kopf 52 in den durchmessergrößeren Abschnitt 46 der Stufenbohrung 45 versenkt eintritt. Durch Festschrauben des Gewindeschraubelements 50 wird somit eine feste Verbindung zwischen der Führungsplatte 3 und der Punktabstützung 6 geschaffen. Am gegenüberliegenden Ende der Punktabstützung 6 ist ebenfalls ein als Gewindeschraubelement 54 ausgebildetes Befestigungselement 51 vorgesehen, das einen Kopf 55 und einen mit Gewinde versehenen Schaft 56 aufweist. Die Führungsplatte 4 ist mit einer Stufenbohrung 57 versehen, die die Führungsplatte 4 durchsetzt und die einen durchmessergrößeren Abschnitt 58 und einen durchmesserkleineren Abschnitt 59 aufweist. Ferner ist zwischen den Führungsplatten 2 und 4 das Abstandsbauteil 7 in Form einer Abstandshülse 60 derart angeordnet, dass die eine Stirnseite 61 der Abstandshülse 60 gegen die Unterseite 62 der Führungsplatte 4 anliegt und die andere Stirnseite 63 der Abstandshülse 60 gegen die Oberseite 64 der Führungsplatte 2 tritt. Durch Einschrauben des Gewindeschraubelements 54 in das Innengewinde 41 der Befestigungsbohrung 39 werden Führungsplatte 4, Abstandsbauteil 7, Führungsplatte 2 und Punktabstützung 6 fest axial miteinander verspannt. Hierbei liegt der Kopf 55 des Gewindeschraubelements 54 im durchmessergrößeren Abschnitt 58 versenkt ein und der Schaft 56 des Gewindeschraubelements 54 durchgreift den durchmesserkleineren Abschnitt 59 der Stufenbohrung 57, eine Innenbohrung 65 der Abstandshülse 60 und greift in die Durchgangsbohrung 44 ein.

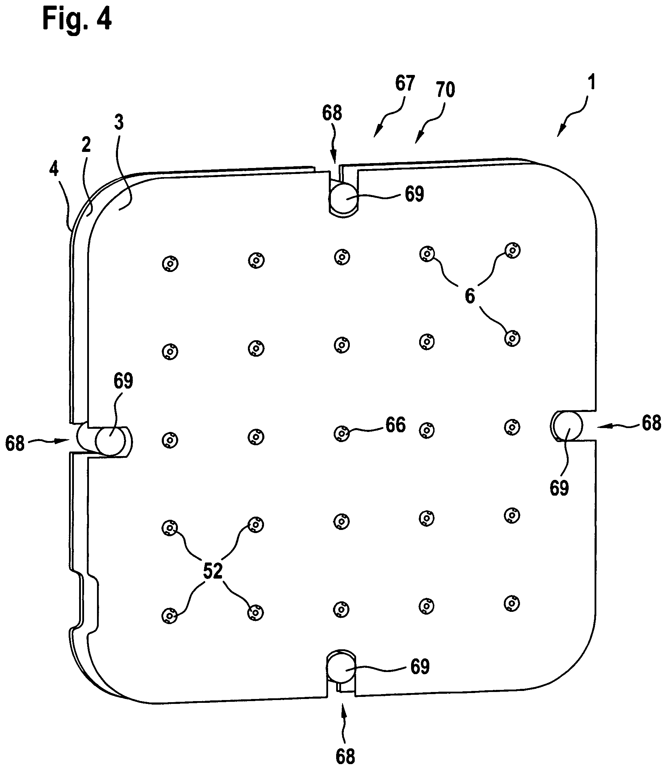

Aus der Figur 4 ist ersichtlich, dass die drei Führungsplatten 2 bis 4 mittels einer Vielzahl von Punktabstützungen 6 miteinander verbunden sind. Bei diesem Ausführungsbeispiel kommen dabei ferner eine entsprechende Anzahl von Abstandsbauelementen 7 zum Einsatz.

Die Punktabstützungen 6 (sowie die Abstandsbauelemente 7) sind vorzugsweise gleichmäßig über die Flächen der zugehörigen Führungsplatten 2 bis 4 verteilt angeordnet. In der Figur 4 ist dies matrixartig realisiert. Aufgrund dieses Zusammenhalts wird eine in sich sehr steife, gegen Durchbiegungen resistente Einheit geschaffen. Wie bereits erwähnt, können die Punktabstützungen - nach einem weiteren, nicht dargestellten Ausführungsbeispiel der Erfindung - auch linienförmig angeordnet sein, um eine gewisse Strebwirkung zu erzeugen. Dabei können vorzugsweise mehrere linienförmige Anordnungen voneinander beabstandet vorgesehen sein.

Die Figur 5 zeigt eine Draufsicht auf die Führungsplatte 3, ohne dass die weiteren Führungsplatten und auch ohne dass die Punktabstützungen 6 dargestellt sind. Es wird deutlich, dass die Gegenelemente 49, die zusammen mit den Elementen 35 die Verdrehsicherungen 36 bilden, derart orientiert über die Fläche der Führungsplatte 3 angeordnet sind, dass die Radialrichtungen 25' bei montierten Punktabstützungen 6 in das Zentrum 66 der Führungsplatte 3 weisen, d.h., die Wirkrichtungen kleinerer mechanischer Festigkeit der einzelnen Punktabstützungen 6 weisen alle in Richtung auf das Zentrum 66. Im Zentrum 66 befindet sich ebenfalls eine Punktabstützung 6, die - wie die dort liegende Stufenbohrung 45 zeigt - ebenfalls drehrichtungsorientiert ist. Die Drehorientierung ist vorzugsweise ebenso wie bei mindestens einer angrenzenden Stufenbohrung 45 ausgerichtet. Die Ausrichtung im Zentrum 66 kann alternativ jedoch beliebig sein.

Zur Ausbildung einer Prüfvorrichtung 67 ist vorgesehen, dass in der Mitte jeder Seite der quadratisch ausgebildeten Führungsplatten 2 bis 4 randoffene Langlochausnehmungen 68 vorhanden sind, die sich in Richtung auf das Zentrum 66 erstrecken. In die Langlochausnehmungen 68 greifen Führungsstifte 69, die ortsfest angeordnet sind, gleitbar ein. Hierdurch ist insgesamt eine Mittenzentriervorrichtung 70 für den Prüfkopf 1 geschaffen, derart, dass er sich beispielsweise aufgrund von Temperaturbeaufschlagung nur von der Mitte her, also vom Zentrum 66 her, gleichmäßig ausdehnt, wobei das Zentrum 66 die Position beibehält.

Wird - gemäß Figur 1 - der Prüfling 17 bei seiner elektrischen Prüfung mit unterschiedlichen Temperaturen beaufschlagt, so wird dies dazu führen, dass die einzelnen Führungsplatten 2 bis 4 sich unterschiedlich stark erwärmen beziehungsweise unterschiedlich stark abkühlen. Die prüflingsnahe Führungsplatte 3 wird sich beispielsweise stärker erwärmen als die weiter entfernt liegende Führungsplatte 2. Da die Punktabstützungen 6 derart winkelorientiert angeordnet sind, dass die Wirkrichtungen kleinerer mechanischer Festigkeit auf das Zentrum 66 gerichtet sind, wird sich diese unterschiedliche Temperaturbeaufschlagung durch ein leichtes Verbiegen der Punktabstützungen 6 bemerkbar machen, wobei das Verbiegen jedoch aufgrund der ausgerichteten Wirkrichtungen der kleineren mechanischen Festigkeit vom Zentrum 66 ausgehend jeweils radial nach au-ßen hin erfolgt, wodurch insgesamt nur minimale Verschiebungen im Bereich der Flächen der Führungsplatten 2 bis 4 auftreten. In diesem Zusammenhang sorgt ferner die erwähnte Mittenzentriervorrichtung 70 ebenfalls für eine immer auf die Mitte, also auf das Zentrum 66, ausgerichtete Verlagerung. Insgesamt werden daher die einzelnen Prüfkontaktstifte 12 nur minimal oder gar nicht durch diese unterschiedlichen Temperaturbeaufschlagungen verlagert, d.h., ihre Berührungskontaktierungen mit dem Prüfling 17 beziehungsweise mit der Kontaktsabstandsvergrößerungsvorrichtung 18 werden nicht negativ beeinflusst. Der Figur 4 ist deutlich zu entnehmen, dass zwischen den einzelnen Punktabstützungen 6 sehr viel freie Fläche der Führungsplatten 2 bis 4 zur Verfügung steht, um dort in entsprechenden Führungsbohrungen 9 bis 11 (die der Einfachheit halber in den Figuren 2 bis 7 nicht dargestellt sind) Prüfkontaktstifte 12 unterzubringen. Hierdurch kann durch ein einziges Absenken des Prüfkopfes 1 auf den Prüfling 17 eine sehr hohe Anzahl von Prüfstromkreisen realisiert werden.

Die Figur 7 verdeutlicht die Anordnung der Figur 4 in perspektivischer, geschnittener Ansicht. Dabei ist ersichtlich, dass die Führungsplatten 3 und 4 mehrschichtig, im dargestellten Ausführungsbeispiel dreischichtig, aufgebaut sein können.

Aufgrund der Erfindung ist das vorstehend erwähnte Durchbiegen der Führungsplatten 2 bis 4 verhindert. Mittels der über die Flächen der Führungsplatten 2 bis 4 verteilt angeordneten Punktabstützungen 6 wird ein sehr steifer Verbund geschaffen, sodass zum Beispiel durch Reibung der Prüfkontaktstifte 12 an den Führungsbohrungen 9 bis 11 keine Verwerfungen der Führungsplatten 2 bis 4 auftreten. In der Z-Richtung (kartesisches Koordinatensystem) sind die Führungsplatten 2 bis 3 somit gegen die erwähnten Verbiegungen geschützt. Um insbesondere durch Temperaturunterschiede auftretende kleine Verschiebungen in X- und Y-Richtung (kartesisches Koordinatensystem) also in den Ebenen der Führungsplatten 2 bis 4, auszugleichen, sind die Punktabstützungen 6 jeweils in einer Radialrichtung 25' "weicher" ausgeführt. Diese Schwächung ist immer auf das Zentrum 66 der Führungsplatten 2 bis 4 ausgerichtet. Hinzu tritt vorzugsweise, dass der Prüfkopf 1 über eine Mittenzentriervorrichtung 70 verfügt, sodass sich der Prüfkopf 1 immer aus dem Zentrum 66 heraus ausdehnt. Die Durchmesser der als Stützstreben 20 ausgebildeten Punktabstützungen 6 betragen vorzugsweise etwa 3 mm. Aufgrund der flächig vereinzelt angeordneten Punktabstützungen 6 sind aus dem Stand der Technik bekannte, unerwünschte Bimetalleffekte und damit Durchbiegungen der Führungsplatten 2 bis 4 verhindert. Ferner nehmen die einzelnen Punktabstützungen 6 nur sehr wenig Raum ein, sodass eine große Fläche zur Anordnung von Prüfkontaktstiften 12 zur Verfügung steht. Aufgrund des Formschlusses der jeweiligen Verdrehsicherung 36 sind die einzelnen Punktabstützungen 6 drehorientiert zur jeweiligen Fläche der Führungsplatten 2 bis 4 angeordnet, wobei sie mit ihrer geschwächten Kontur stets auf das Zentrum 66 weisen. Auch bei während der Prüfung eines Prüflings 17 erfolgendem Temperaturzyklus, von beispielsweise - 40°C bis + 180°C, sind keine derartig großen Verbiegungen der Führungsplatten 2 bis 4 zu befürchten, dass der erwähnte Scrub beeinträchtigt wäre und/oder Rissbildungen in den Führungsplatten, die insbesondere aus Keramik bestehen, auftreten könnten.

Gemäß dem in den Figuren 1 bis 7 dargestellten Ausführungsbeispiel liegen die Köpfe 55 der Gewindeschraubelemente 54 versenkt zur Oberfläche (Oberseite 16) der Führungsplatte 4. Es ist jedoch auch denkbar, dass durch entsprechende Unterlegscheiben die Köpfe 55 die Oberfläche überragen, sodass eine Abstützung der Köpfe 55 und damit des Prüfkopfs 1 an einem Nachbarbauteil, beispielsweise an der erwähnten Kontaktsabstandsvergrößerungsvorrichtung 18 durchgeführt werden kann. Dies ergibt einen steifen und hinsichtlich der Lage der Bauteile reproduzierbaren Aufbau.

## Patentansprüche

1. Prüfkopf für die elektrische Prüfung eines Prüflings (17), insbesondere Wafers, mit mindestens zwei, mittels mindestens eines Abstandshalters (5) beabstandet zueinander angeordneten Führungsplatten (2,3,4), die über ihre Flächen verteilt angeordnete Führungsbohrungen (9,10,11) aufweisen, in denen Prüfkontaktstifte (12) zur Berührungskontaktierung des Prüflings (17) verschieblich geführt sind, wobei der Abstandshalter (5) von einer Vielzahl von über die Flächen der Führungsplatten (2,3,4) verteilt angeordneten, an den Führungsplatten (2,3,4) befestigten Punktabstützungen (6) gebildet ist, wobei jede der Punktabstützungen (6) eine Längserstreckungsrichtung (24) und quer, insbesondere rechtwinklig, dazu, eine Vielzahl von über einen Winkelbereich von 360° verteilte Radialrichtungen aufweist, **dadurch gekennzeichnet, dass** die mechanische Festigkeit jeder der Punktabstützungen (6) in mindestens einer der Radialrichtungen (25') kleiner ist als in den anderen Radialrichtungen (25), wobei die Punktabstützungen (6) derart drehorientiert über die Flächen der Führungsplatten (2,3,4) angeordnet sind, dass die Wirkrichtungen der kleineren mechanischen Festigkeit der einzelnen Punktabstützungen (6) alle auf das Zentrum (66) der jeweiligen Führungsplatte (2,3,4) weisend ausgerichtet sind.

2. Prüfkopf nach Anspruch 1, **dadurch gekennzeichnet, dass** die eine Führungsplatte (2) eine erste Führungsplatte (2) und dass die andere Führungsplatte (3) eine zweite Führungsplatte (3) ist, wobei die zweite Führungsplatte (3) eine prüflingsnahe Führungsplatte (3) und die erste Führungsplatte (2) eine prüflingsentfernte Führungsplatte (2) ist.

3. Prüfkopf nach Anspruch 2, **dadurch gekennzeichnet, dass** eine weitere, dritte Führungsplatte (4) vorgesehen ist, die benachbart zur ersten Führungsplatte (2) angeordnet ist, wobei jedem Prüfkontaktstift (12) eine erste Führungsbohrung (9) in der ersten Führungsplatte (2), eine zweite Führungsbohrung (10) in der zweiten Führungsplatte (3) und eine dritte Führungsbohrung (11) in der dritten Führungsplatte (4) zugeordnet ist, wobei die zweite und dritte Führungsbohrung (10,11) miteinander fluchten und die erste Führungsbohrung (9) versetzt zu der Fluchtung von der zweiten und dritten Führungsbohrung (10,11) liegt oder alle drei Führungsbohrungen (9,10,11) zueinander versetzt liegen.

4. Prüfkopf nach einem der vorhergehenden Ansprüche, **dadurch gekennzeichnet, dass** die Punktabstützungen (6) als Stützstreben (20), insbesondere druck- und zugfeste Stützstreben (20), ausgebildet sind.

5. Prüfkopf nach einem der vorhergehenden Ansprüche, **dadurch gekennzeichnet, dass** jede der Punktabstützungen (6) zur Erzielung der kleineren mechanischen Festigkeit mindestens eine Querschnittsschwächungszone (26) aufweist.

6. Prüfkopf nach einem der vorhergehenden Ansprüche, **dadurch gekennzeichnet, dass** jede der Punktabstützungen (6) auf einander gegenüberliegenden Seiten ihres Umfangs jeweils eine Querschnittsschwächungszone (26) aufweist.

7. Prüfkopf nach Anspruch 5, **dadurch gekennzeichnet, dass** jede der Punktabstützungen (6) in Längserstreckungsrichtung (24) eine erste Endzone (21), daran anschließend eine Mittelzone (22) und daran anschließend eine zweite Endzone (23) aufweist, und dass die Mittelzone (22) die mindestens eine Querschnittsschwächungszone (26) besitzt.

8. Prüfkopf nach Anspruch 7, **dadurch gekennzeichnet, dass** jede der Punktabstützungen (6) im Bereich der Querschnittsschwächungszone (26) mindestens einen Durchbruch (31) aufweist.

9. Prüfkopf nach Anspruch 8, **dadurch gekennzeichnet, dass** die Tiefenerstreckung des Durchbruchs (31) in einer Radialrichtung (25') vorliegt, die gleich ist wie die Radialrichtung (25), der die kleinere mechanische Festigkeit aufgrund der mindestens einen Querschnittsschwächungszone (26) zugeordnet ist.

10. Prüfkopf nach einem der Ansprüche 8 und 9, **dadurch gekennzeichnet, dass** durch den mindestens einen Durchbruch (31) mindestens zwei Stützarme (32) zwischen den beiden Endzonen (21,23) der jeweiligen Punktabstützung (6) ausgebildet sind.

11. Prüfkopf nach Anspruch 10, **dadurch gekennzeichnet, dass** die Stützarme (32) zueinander parallel verlaufen, und dass die Stützarme (32) parallel zur Längserstreckungsrichtung (24) der jeweiligen Punktabstützung (6) verlaufen.

12. Prüfkopf nach einem der Ansprüche 7 bis 11, **dadurch gekennzeichnet, dass** die beiden Endzonen (21,23) Stirnseiten (33,34) zum Abstützen an den Führungsplatten (2,3,4) aufweisen.

13. Prüfkopf nach Anspruch 12, **dadurch gekennzeichnet, dass** an mindestens einer der Stirnseiten (33,34) der jeweiligen Punktabstützung (6) ein Element (35) einer Verdrehsicherung (36) vorhanden ist, das mit einem zur Verdrehsicherung (36) gehörenden Gegenelement (49) an der zugeordneten Führungsplatte (2,3,4) zusammenwirkt.

14. Prüfkopf nach einem der Ansprüche 12 und 13, **dadurch gekennzeichnet, dass** die Stirnseiten (33,34) der jeweiligen Punktabstützung (6) mit Befestigungsbohrungen (38,39), insbesondere Gewindebohrungen, versehen sind, in die die Führungsplatten (2,3,4) durchgreifende Befestigungselemente (51), insbesondere Gewindeschraubelemente (50,54), mit Enden ihrer Schäfte (53,56) eingreifen.

15. Prüfkopf nach einem der Ansprüche 13 und 14, **dadurch gekennzeichnet, dass** das Element (35) der Verdrehsicherung (36) mindestens ein von der zugehörigen Befestigungsbohrung (38,39) radial beabstandeter Vorsprung (37) ist und dass das Gegenelement (49) eine Vertiefung (48) in der Führungsplatte (2,3,4) ist.

16. Prüfkopf nach Anspruch 14, **dadurch gekennzeichnet, dass** die einer der Stirnseiten (33,34) zugeordneten Befestigungselemente (51) mit ihren Schäften (53,56) zwei der Führungsplatten (2,3,4) durchgreifen, wobei zwischen diesen beiden Führungsplatten (2,3,4) Abstandsbauteile (7), insbesondere von den Schäften (53,56) durchsetzte Abstandshülsen (60), angeordnet sind, die sich an diesen Führungsplatten (2,3,4) abstützen.

17. Prüfkopf nach einem der vorhergehenden Ansprüche, **dadurch gekennzeichnet, dass** zur Ausbildung einer Mittenzentriervorrichtung (70) für die Aufnahme von mindestens drei Führungsstiften (69) mindestens drei Langlochausnehmungen (68) vorgesehen sind, wobei die Längserstreckungsrichtungen der Langlochausnehmungen (68) auf das Zentrum (66) der jeweiligen Führungsplatte (2,3,4) weisend ausgerichtet sind.

18. Prüfvorrichtung (67) mit einem Prüfkopf (1) nach Anspruch 17, **gekennzeichnet durch** die mindestens drei vorzugsweise ortsfest angeordneten Führungsstifte (69), die in die mindestens drei Langlochausnehmungen (68) in der jeweiligen Längserstreckungsrichtung der Langlochausnehmungen (68) gleitbar eingreifen.

## Claims

1. Test head for the electrical testing of a test object (17), in particular a wafer, comprising at least two guide plates (2, 3, 4) arranged at a distance from one another by means of at least one spacer (5) and comprising guide bores (9, 10, 11) distributed over their surfaces, in which test contact pins (12) for contacting the test object (17) are displaceably guided, wherein the spacer (5) is formed by a plurality of point supports (6) distributed over the surfaces of the guide plates (2, 3, 4) and fastened to the guide plates (2, 3, 4), wherein each of the point supports (6) has a longitudinal direction (24) and transversely, in particular at right angles thereto, a plurality of radial directions distributed over an angular range of 360°, **characterized in that** the mechanical strength of each of the point supports (6) is smaller in at least one of the radial directions (25') than in the other radial directions (25), wherein the point supports (6) are arranged rotationally oriented over the surfaces of the guide plates (2, 3, 4) in such a way that the effective directions of the smaller mechanical strength of the individual point supports (6) are all oriented towards the centre (66) of the respective guide plate (2, 3, 4).

2. Test head according to claim 1, **characterized in that** the one guide plate (2) is a first guide plate (2) and that the other guide plate (3) is a second guide plate (3), the second guide plate (3) being a guide plate (3) close to the test object and the first guide plate (2) being a guide plate (2) remote from the test object.

3. Test head according to claim 2, **characterized in that** a further, third guide plate (4) is provided which is arranged adjacent to the first guide plate (2), wherein each test contact pin (12) has a first guide bore (9) in the first guide plate (2), a second guide bore (10) in the second guide plate (3) and a third guide bore (11) in the third guide plate (4) being assigned to each test contact pin (12), wherein the second and third guide bores (10, 11) are aligned with one another and the first guide bore (9) is offset from the alignment of the second and third guide bores (10, 11) or all three guide bores (9, 10, 11) are offset from one another.

4. Test head according to one of the preceding claims, **characterized in that** the point supports (6) are designed as support struts (20), in particular compression- and tension-resistant support struts (20).

5. Test head according to one of the preceding claims, **characterized in that** each of the point supports (6) has at least one cross-sectional weakening zone (26) for achieving the smaller mechanical strength.

6. Test head according to one of the preceding claims, **characterized in that** each of said point supports (6) has a respective cross-sectional weakening zone (26) on opposite sides of its circumference.

7. Test head according to claim 5, **characterized in that** each of the point supports (6) has, in the longitudinal direction (24), a first end zone (21), adjoining it a middle zone (22) and adjoining it a second end zone (23), and **in that** the middle zone (22) has the at least one cross-sectional weakening zone (26).

8. Test head according to claim 7, **characterized in that** each of the point supports (6) has at least one aperture (31) in the region of the cross-sectional weakening zone (26).

9. Test head according to claim 8, **characterized in that** the depth extension of the aperture (31) is in a radial direction (25') which is the same as the radial direction (25) to which the smaller mechanical strength is assigned due to the at least one cross-sectional weakening zone (26).

10. Test head according to one of claims 8 and 9, **characterized in that** at least two support arms (32) are formed through the at least one aperture (31) between the two end zones (21, 23) of the respective point support (6).

11. Test head according to claim 10, **characterized in that** the support arms (32) extend parallel to one another, and **in that** the support arms (32) extend parallel to the longitudinal direction (24) of the respective point support (6).

12. Test head according to one of claims 7 to 11, **characterized in that** the two end zones (21, 23) have end faces (33, 34) for support on the guide plates (2, 3, 4).

13. Test head according to claim 12, **characterized in that** on at least one of the end faces (33,34) of the respective point support (6) there is an element (35) of an anti-rotation device (36) which interacts with a counter-element (49) belonging to the anti-rotation device (36) on the associated guide plate (2,3,4).

14. Test head according to one of claims 12 and 13, **characterized in that** the end faces (33, 34) of the respective point support (6) are provided with fastening bores (38, 39), in particular threaded bores, into which fastening elements (51), in particular threaded screw elements (50, 54), engaging through the guide plates (2, 3, 4) engage with ends of their shanks (53, 56).

15. Test head according to one of claims 13 and 14, **characterized in that** the element (35) of the anti-rotation device (36) is at least one projection (37) radially spaced from the associated fastening bore (38,39) and that the counter-element (49) is a recess (48) in the guide plate (2,3,4).

16. Test head according to claim 14, **characterized in that** the fastening elements (51) associated with one of the end faces (33, 34) engage with their shafts (53, 56) through two of the guide plates (2, 3, 4), wherein spacer components (7), in particular spacer sleeves (60) through which the shafts (53, 56) pass, are arranged between these two guide plates (2, 3, 4) and are supported on these guide plates (2, 3, 4).

17. Test head according to one of the preceding claims, **characterized in that** at least three slot recesses (68) are provided for forming a middle centring device (70) for receiving at least three guide pins (69), wherein the longitudinal directions of the slot recesses (68) are aligned pointing towards the centre (66) of the respective guide plate (2,3,4).

18. Test device (67) with a test head (1) according to claim 17, **characterized by** the at least three guide pins (69) which are preferably arranged in a stationary manner and which engage in a slidable manner in the at least three slot recesses (68) in the respective longitudinal direction of the slot recesses (68).

## Revendications

1. Tête de test pour le contrôle électrique d'un échantillon (17), en particulier d'un wafer, avec au moins deux plaques de guidage (2, 3, 4) disposées à distance l'une de l'autre au moyen d'au moins une entretoise (5), qui présentent des alésages de guidage (9, 10, 11) répartis sur leurs surfaces, où des broches de contact de test (12) sont guidées de manière coulissante pour établir le contact avec l'échantillon (17), l'entretoise (5) étant formée par une pluralité de supports ponctuels (6) répartis sur les surfaces des plaques de guidage (2, 3, 4) et fixés sur les plaques de guidage (2, 3, 4), chacun des supports ponctuels (6) présentant une direction d'extension longitudinale (24) et transversalement à celle-ci, notamment perpendiculairement, une pluralité de directions radiales réparties sur une zone angulaire de 360°, **caractérisé en ce que** la résistance mécanique de chacun des supports ponctuels (6) est plus faible dans au moins une des directions radiales (25') que dans les autres directions radiales (25), dans laquelle les supports ponctuels (6) sont disposés avec une orientation en rotation sur les surfaces des plaques de guidage (2, 3, 4) de telle sorte que les directions d'action de la résistance mécanique plus faible des différents supports ponctuels (6) sont toutes orientées vers le centre (66) de la plaque de guidage (2, 3, 4) correspondante.

2. Tête de test selon la revendication 1, **caractérisée en ce qu'**une plaque de guidage (2) est une première plaque de guidage (2) et **en ce que** l'autre plaque de guidage (3) est une deuxième plaque de guidage (3), la deuxième plaque de guidage (3) étant une plaque de guidage (3) proche de l'échantillon et la première plaque de guidage (2) étant une plaque de guidage (2) éloignée de l'échantillon.

3. Tête de test selon la revendication 2, **caractérisée en ce qu'**il est prévu une autre, troisième plaque de guidage (4) qui est disposée à côté de la première plaque de guidage (2), dans laquelle à chaque broche de contact de test (12) est associé un premier alésage de guidage (9) dans la première plaque de guidage (2), un deuxième alésage de guidage (10) dans la deuxième plaque de guidage (3) et un troisième alésage de guidage (11) dans la troisième plaque de guidage (4), les deuxième et troisième alésages de guidage (10, 11) étant alignés entre eux et le premier alésage de guidage (9) étant décalé par rapport à l'alignement des deuxième et troisième alésages de guidage (10, 11) ou les trois alésages de guidage (9, 10, 11) étant décalés entre eux.

4. Tête de test selon l'une des revendications précédentes, **caractérisée en ce que** les supports ponctuels (6) sont conçus comme des barres d'appui (20), en particulier de barres d'appui (20) résistantes à la compression et à la traction.

5. Tête de test selon l'une des revendications précédentes, **caractérisée en ce que** chacun des supports ponctuels (6) présente au moins une zone d'affaiblissement de la section transversale (26) pour obtenir la plus faible résistance mécanique.

6. Tête de test selon l'une des revendications précédentes, **caractérisée en ce que** chacun des supports ponctuels (6) présente une zone d'affaiblissement de la section transversale (26) respectivement sur des côtés opposés de sa périphérie.

7. Tête de test selon la revendication 5, **caractérisée en ce que** chacun des supports ponctuels (6) présente, dans la direction d'extension longitudinale (24), une première zone d'extrémité (21), suivie d'une zone centrale (22) et suivie d'une deuxième zone d'extrémité (23), et **en ce que** la zone centrale (22) comporte l'au moins une zone d'affaiblissement de la section transversale (26).

8. Tête de test selon la revendication 7, **caractérisée en ce que** chacun des supports ponctuels (6) présente au moins un ajour (31) au niveau de la zone d'affaiblissement de la section transversale (26).

9. Tête de test selon la revendication 8, **caractérisée en ce que** l'extension en profondeur de l'ajour (31) est dans une direction radiale (25') qui est la même que la direction radiale (25), à laquelle est associée la plus faible résistance mécanique due à l'au moins une zone d'affaiblissement de la section transversale (26).

10. Tête de test selon l'une des revendications 8 et 9, **caractérisée en ce qu'**au moins deux bras d'appui (32) sont conçus à travers l'au moins un ajour (31) entre les deux zones d'extrémité (21, 23) du support ponctuel (6) respectif.

11. Tête de test selon la revendication 10, **caractérisée en ce que** les bras d'appui (32) se prolongent parallèlement les uns aux autres, et **en ce que** les bras d'appui (32) se prolongent parallèlement à la direction d'extension longitudinale (24) du support ponctuel (6) respectif.

12. Tête de test selon l'une des revendications 7 à 11, **caractérisée en ce que** les deux zones d'extrémité (21, 23) présentent des faces frontales (33, 34) pour s'appuyer sur les plaques de guidage (2, 3, 4).

13. Tête de test selon la revendication 12, **caractérisée en ce que** sur au moins l'une des faces frontales (33, 34) du support ponctuel (6) respectif existe un élément (35) d'un dispositif anti-rotation (36) qui coopère avec un contre-élément (49) appartenant au dispositif anti-rotation (36) sur la plaque de guidage (2, 3, 4) associée.

14. Tête de test selon l'une des revendications 12 et 13, **caractérisée en ce que** les faces frontales (33, 34) du support ponctuel (6) respectif sont pourvues de trous de fixation (38, 39), notamment de trous taraudés, dans lesquels des éléments de fixation (51) traversant les plaques de guidage (2, 3, 4), notamment des éléments de vis filetées (50, 54), s'engagent par les extrémités de leurs tiges (53, 56).

15. Tête de test selon l'une des revendications 13 et 14, **caractérisée en ce que** l'élément (35) du dispositif anti-rotation (36) est au moins une saillie (37) espacée radialement du trou de fixation (38, 39) correspondant et **en ce que** le contre-élément (49) est une cavité (48) dans la plaque de guidage (2, 3, 4).

16. Tête de test selon la revendication 14, **caractérisée en ce que** les éléments de fixation (51) associés à l'une des faces frontales (33, 34) traversent par leurs tiges (53, 56) deux des plaques de guidage (2, 3, 4), des éléments d'écartement (7), notamment des douilles d'écartement (60) traversées par les tiges (53, 56), étant disposés entre ces deux plaques de guidage (2, 3, 4) qui s'appuyant sur ces plaques de guidage (2, 3, 4).

17. Tête de test selon l'une des revendications précédentes, **caractérisée en ce que**, pour former un dispositif de positionnement central (70) destiné à recevoir au moins trois broches de guidage (69), il est prévu au moins trois évidements à trous oblongs (68), les directions d'extension longitudinale des évidements à trous oblongs (68) étant orientées en direction du centre (66) de la plaque de guidage (2, 3, 4) correspondante.

18. Dispositif de test (67) avec une tête de test (1) selon la revendication 17, **caractérisé par** les au moins trois broches de guidage (69) disposées de préférence de manière fixe, qui s'engagent de sorte à pouvoir coulisser dans les au moins trois évidements à trous oblongs (68) dans la direction d'extension longitudinale respective des évidements à trous oblongs (68).
